# EUROPEAN PATENT APPLICATION

(11) **EP 4 738 357 A1**
(43) Date of publication of application: **06.05.2026**
(21) Application number: 25211131.5
(22) Date of filing: 24.10.2025
(51) Int. Cl.: G11C 5/04, H10W 42/00, H10W 72/00, H10W 72/50, H10W 74/00, H10W 80/00

(54) **PRE-PATTERNED ADHESIVE TAPE FOR ENABLING DOUBLE-SIDED CIRCUIT ASSEMBLY**

(30) Priority: 30.10.2024 US 202418931396
(71) Applicant: NXP USA, Inc., Austin, TX 78735 (US)
(72) Inventor: Kanth, Namrata, 5656AG Eindhoven (NL); Hayes, Scott M, 5656AG Eindhoven (NL); Hooper, Stephen Ryan, 5656AG Eindhoven (NL); Shade, Douglas Michael, 5656AG Eindhoven (NL)
(74) Representative: Colaiuda, Antonella

(57) **Abstract**

A method of producing a circuit die where the method includes applying a pre-patterned backing tape to a first surface of a semiconductor substrate that includes the first surface and a second surface, the second surface including one or more circuits; coating the second surface with an encapsulant; removing a patterned portion of the pre-patterned backing tape to expose one or more contact pads on the first surface; applying one of an electrically conductive adhesive (ECA) or solder to the one or more contact pads on the first surface; and coupling an electrical component to the contact pads using the ECA or solder.

## Description

### FIELD OF USE

The present disclosure generally relates to semiconductor circuits, and more particularly to double-sided circuits including a patterned adhesive tape and methods of assembly using pre-patterned adhesive tape.

### BACKGROUND

Adhesive tape with high thermal and electrical insulation properties, such as Kapton^{®} tape produced by Dupont Electronics, Inc. of Delaware, is often used during microelectronic package assembly, for example, as a solder mask or heat protector, to mask areas during painting or plating, to splice together flexible printed circuit boards, or for packaging semiconductors.

### BRIEF DESCRIPTION OF THE DRAWINGS

The detailed description is set forth with reference to the accompanying figures. In the figures, the left-most digit(s) of a reference number identifies the figure in which the reference number first appears. The use of the same reference numbers in different figures and in the detailed description indicates similar or identical items or features.
FIG. 1A depicts a cross-sectional view of a portion of a microelectronic package array including a lead frame with one or more circuits and with pre-patterned backing tape, in accordance with one or more embodiments.
FIG. 1B depicts a top view of the portion of the microelectronic package array of FIG. 1A including the pre-patterned backing tape and showing a first portion that remains on the substrate and a second portion that is removable according to the pattern, in accordance with one or more embodiments.
FIG. 2 depicts a first portion of a method of producing a circuit die including producing microelectronic package array including a lead frame with exposed bond pads for attaching a battery or circuit components, in accordance with one or more embodiments.
FIG. 3 depicts a second portion of the method of producing the circuit die including applying conductive material to the exposed bond pads, attaching a device, applying a coating, and singulating a microelectronic package from the microelectronic package array, in accordance with one or more embodiments.
FIG. 4A depicts a cross-sectional view of the circuit of FIG. 3 including a conformal coating, in accordance with one or more embodiments.
FIG. 4B depicts a cross-sectional view of the circuit of FIG. 3 including an encapsulant, in accordance with one or more embodiments.
FIG. 5A depicts an embodiment of the circuit of FIG. 3 implemented as a fan-out wafer-level chip scale package (FO-WLCSP), in accordance with one or more embodiments.
FIG. 5B depicts an embodiment of the circuit of FIG. 3 implemented as a flip-chip package, in accordance with one or more embodiments.
FIG. 5C depicts an embodiment of the circuit of FIG. 3 implemented as a mold-array process ball grid array (MAP BGA), in accordance with one or more embodiments.
FIG. 6 depicts a flow diagram of a method of producing a circuit die using a pre-patterned adhesive tape, in accordance with one or more embodiments.

While implementations are described in this disclosure by way of example, those skilled in the art will recognize that the implementations are not limited to the examples or figures described. Rather, the figures and detailed description thereto are not intended to limit implementations to the form disclosed, but instead the intention is to cover all modifications, equivalents, and alternatives falling within the scope as defined by the appended claims. The headings used in this disclosure are for organizational purposes only and are not meant to limit the scope of the description or the claims. As used throughout this application, the word "may" is used in a permissive sense (in other words, the term "may" is intended to mean "having the potential to") instead of in a mandatory sense (as in "must"). Similarly, the terms "include," "including," and "includes" mean "including, but not limited to."

### DETAILED DESCRIPTION

In one or more embodiments, a method or process flow may begin with a processed microelectronic package array, which may have received back-grinding processing. As used herein, the term "microelectronic package array" refers to a semiconductor substrate with a first side upon which distinct active circuit areas are formed. Each distinct active circuit area may include an active circuit area, one or more conductive pads on a top surface, scribe-lane areas between the active circuit areas, and optionally a seal-ring structure. A dielectric material may be deposited conformally onto a top surface of each of the active circuit areas and on the sidewalls.

Embodiments of circuits and methods are described below that utilize a backing tape, such as Kapton^{®} tape produced by Dupont Electronics, Inc. of Delaware, to prevent resin bleed. The backing tape may be formed from polyimide-based or polyethylene-based material that remains stable across a wide-range of temperatures (such as from -269 degrees Celsius to +400 degrees Celsius) and that is electrically insulative. The backing tape may be coated with a silicone adhesive to enable adhesion to the microelectronic package array. The backing tape may be pre-patterned to facilitate subsequent removal of a portion of the backing tape to expose one or more contact pads. The pre-patterned tape may be applied as the backing tape and then resin may be disposed on an active surface of the microelectronic package array that includes the active circuit areas. The pre-patterned tape may be configured to prevent resin bleed.

After applying the pre-patterned tape as a backing tape and after application of the resin, the patterned portion of the pre-patterned adhesive tape may be removed to reveal or expose portions of the lead frame or substrate for enabling backside assembly. In one or more embodiments, the patterned portion may align with conductive pads, such that removal of the patterned portion may expose the conductive pads. Solder or an electrically conductive adhesive (ECA) may be applied to the exposed conductive pads to enable attachment of a battery or other circuit components. The portion of the adhesive tape that is not removed may remain in place to provide electrical insulation between the attached battery or other circuit components to prevent the die attachment from contacting adjacent terminals.

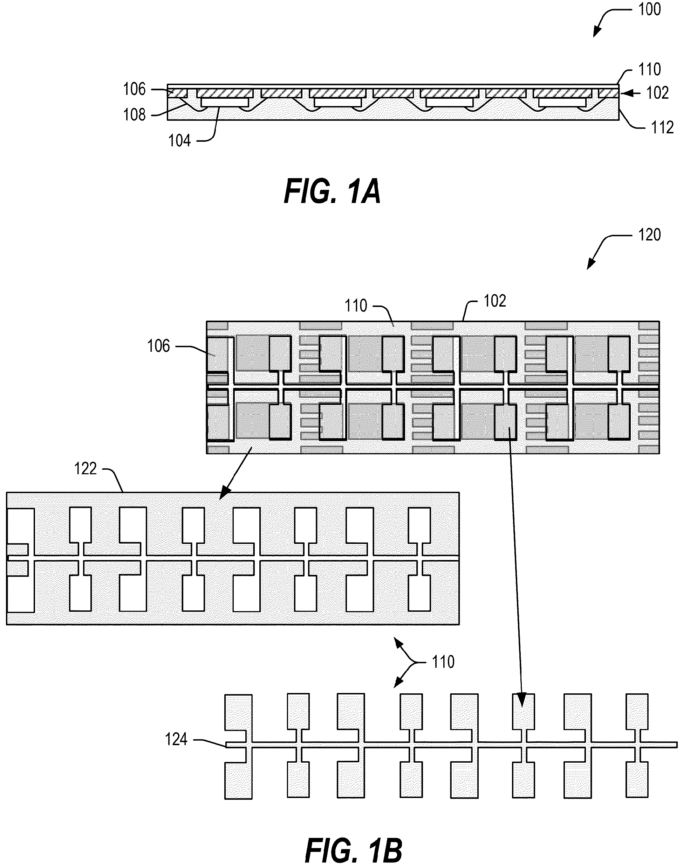

In one or more embodiments, the pre-patterned adhesive tape may be used to enable microelectronic backside assembly to a lead frame or substrate. In one or more embodiments, the patterned portion of the adhesive tape may be removed to expose one or more bond pads or electrical contacts, and the remaining portion of the adhesive tape may function as a mask as an electrically conductive adhesive (ECA) or solder is applied to the exposed bond pads or electrical contacts. A battery or a circuit component may be coupled to the exposed bond pads by the ECA or solder and a conformal coating or an encapsulant may be applied over the battery or circuit component. In one or more embodiments, the pre-patterned adhesive tape may be used to enable installation of a coin-battery in the microelectronic package. In one or more embodiments, the conformal coating can be formed from HumiSeal, parylene, or other coating material. These coating may be dielectric, may provide moisture protection, and may provide an insulation barrier for semiconductor circuits. In one or more embodiments, the encapsulant may include epoxy-based material, acrylic-based material, urethane-based material, or any combination thereof. In one or more embodiments, the selection of material composition may depend on protection requirements of the application and needs of the battery and circuit components. An example of a semiconductor substrate including a pre-patterned backing tape is described below with respect to FIG. 1A.

FIG. 1A depicts a cross-sectional view of a portion of a microelectronic package array 100 including a substrate 102 with one or more circuits, such as a circuit die 104, and with pre-patterned backing tape 110, in accordance with one or more embodiments. In the illustrated embodiment, the substrate 102 may be an embodiment of a lead frame that is a metal array, which may be encapsulated after circuit die 104 and wire bonding 106. In one or more other embodiments, the substrate 102 may include one or more layers, such as metal layers and dielectric layers, and may include electrically conductive vias that may extend between one or more of the metal layers through the dielectric layers.

In the illustrated embodiments, a substrate 102 is shown that is a lead frame with a single metal layer that is patterned to provide a plurality of electrically conductive contact pads 106 similar to a lead frame used in wire-bonded microelectronic packages. Circuit die 104 may be coupled to one or more of the contact pads 106. In the illustrated example, the circuit die 104 may be coupled to one of the contact pads 106 directly and may be coupled to adjacent contact pads 106 by bond wires 108. The side of the metallization layer that includes the circuit die 104 may be described as the active circuit area or the active side of the circuit.

A pre-patterned backing tape 110 may be applied to a backside surface across the plurality of contact pads 106. After the pre-patterned backing tape 110 is applied, a conformal coating or encapsulant 112 such as mold compound in leadframe based packages may be applied to the active side of the circuit. The pre-patterned backing tape 110 may prevent resin bleed from the application of the conformal coating or encapsulant 112.

In one or more embodiments, the pre-patterned backing tape 110 may include a Kapton^{®} tape, produced by Dupont Electronics, Inc. of Delaware. In one or more embodiments, the pre-patterned backing tape 110 may be formed from a polyimide-based material, a polyethylene-based material, or another material that remains stable across a wide range of temperatures, and especially that remains stable through an operating temperature range of the circuit and preferably that remains stable at temperatures corresponding to solder during the application process.

In one or more embodiments, the pre-patterned backing tape 110 may be stamped, etched, or otherwise processed to provide a patterned portion that may be removed to expose the underlying contact pads 106. In one or more embodiments, the pre-patterned backing tape 110 may include a first portion that is patterned and that can be removed and may include a second portion that provides a stencil for exposing the contact pads 106 while protecting the underlying (unexposed) surface areas.

FIG. 1B depicts a top view 120 of the portion of the microelectronic package array 100 of FIG. 1A including the pre-patterned backing tape 110 and showing a first portion 122 that remains on the substrate 102 and a second portion (patterned portion) 124 that is removable according to the pattern, in accordance with one or more embodiments. In this example, the top view 120 depicts the microelectronic package array 100 with the contact pads 106 visible through the pre-patterned backing tape 110.

The first portion 122 and the patterned portion 124 of the pre-patterned backing tape 110 are shown in a partial exploded view with the patterned portion 124 removed. It should be appreciated that the patterned portion 124 depicted in FIG. 1B represents one possible example of a pattern, but that any number of patterns may be produced for the pre-patterned backing tape 110 that may correspond to selected contact pads 106 of a given microelectronic package array 100.

In the illustrated embodiment, the substrate 102 is depicted as a single layer of metal. The substrate 102 is a metal array that may be encapsulated after circuit die 104 and wire-bonding 108. The spaces between the metal array of the substrate 102 may filled by the dielectric material 112. In one or more other embodiments, the substrate 102 may include one or more metal layers, one or more dielectric layers, and electrical interconnects extending between the metal layers.

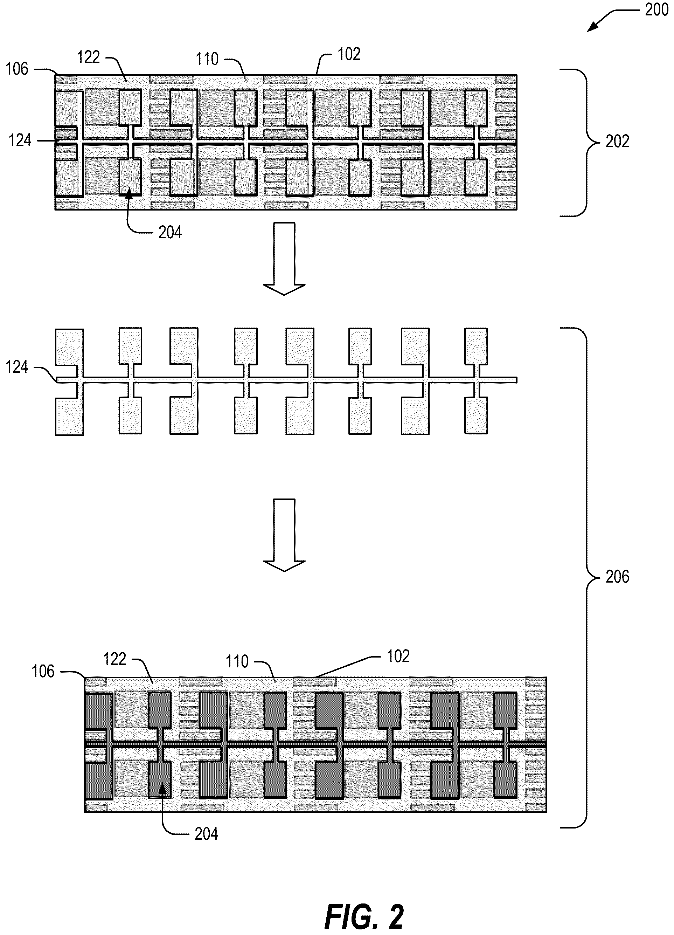

FIG. 2 depicts a first portion of a method 200 of producing a circuit die including producing microelectronic package array 100 including a substrate 102 with exposed contact pads 106 for attaching a battery or circuit components, in accordance with one or more embodiments. In one or more embodiments, the attached battery may be a coin battery or other power source. In one or more embodiments, the circuit components may include circuit components (e.g., resistors, capacitors, inductors, and the like) or other circuits.

At 202, the method 200 may include providing a molded lead frame 102 that includes multiple contact pads 106 and that includes an active side that includes a circuit die electrically coupled to one or more of the contact pads 106 and that is sealed or covered by a conformal coating or an encapsulant 112. The backside of the lead frame 102 includes the pre-patterned backing tape 110. The pre-patterned backing tape 110 may include a first portion 122 that is configured to remain on the lead frame 102 and a patterned portion 124 that is configured to be removed from the lead frame 102 to expose selected areas 204, which may include a contact pad 106.

At 206, the method 200 may include removing the patterned portion 124 of the pre-patterned backing tape 110 to provide the lead frame 102 including exposed areas 204 that include contact pads (bond pads) 106 for attachment of a battery, a circuit component, or any combination thereof. The first portion 122 of the pre-patterned backing tape 110 remains on the backside of the lead frame 102 to protect unexposed areas.

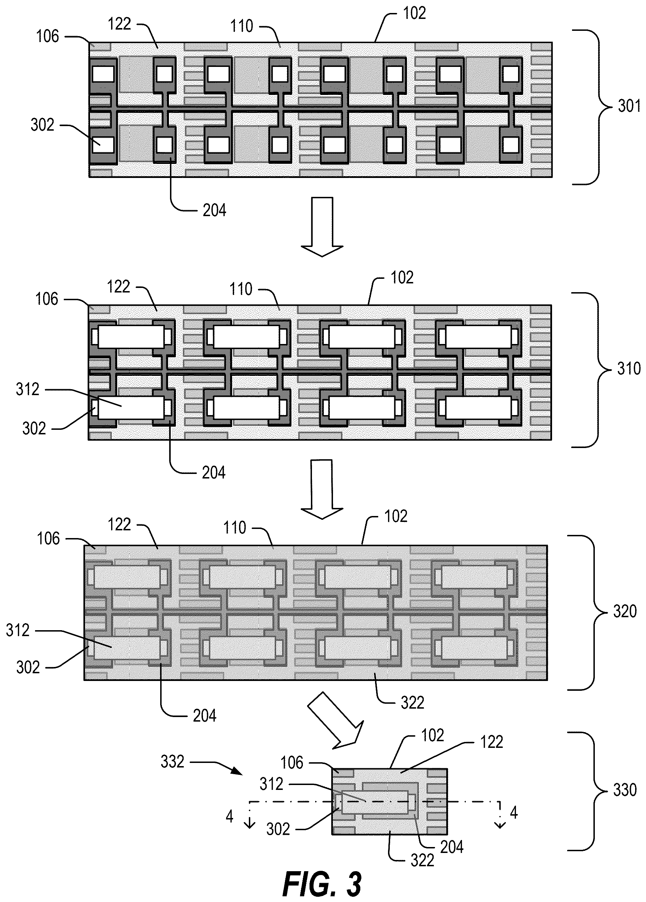

The lead frame 102 and the various elements shown in FIG. 2 are depicted for illustrative purposes only and are not necessarily drawn to scale. Moreover, the patterned portion 124 is shown for illustrative purposes and any number of patterns may be used for different circuit configurations, different batteries, different circuit components, or any combination thereof. The method 200 continues in FIG. 3.

FIG. 3 depicts a second portion of the method 200 of FIG. 2 for producing idea microelectronic package including applying conductive material to the exposed bond pads, attaching a device, applying a coating, and cutting (singulating) the microelectronic package from the microelectronic package array, in accordance with one or more embodiments. At 301, the method 200 may include applying electrically conductive material 302 onto the contact pads 106 in the exposed areas 204 on the back of the substrate 102. The electrically conductive material 302 may include an electrically conductive adhesive, solder, or the like. The first portion 122 of the pre-patterned backing tape 110 may protect the unexposed contact pads 106 and other areas of the substrate 102 from the electrically conductive material 302. In one or more embodiments, applying the electrically conductive material 302 onto the contact pads 106 may include dispensing electrically conductive adhesive (ECA) or screen-printing solder onto the contact pads 106 within the exposed areas 204.

At 310, the method 200 may include attaching one or more of a battery or a circuit component to the electrically conductive material 302 on the contact pads 106 in the exposed areas 204. In one or more embodiments, one or more batteries be coupled to the electrically conductive material 302. The one or more batteries may include a coin battery or other battery. The one or more circuit components may include one or more of a resistor, an inductor, a capacitor, another circuit.

At 320, the method 200 may include coating or encapsulating the back surface of the substrate 102 including over first portion 122 of the pre-patterned backing tape 110, the exposed areas 204, the electrically conductive material 302, and the one or more components (batteries, electrical components, circuits, or any combination thereof). The coating may include a conformal coating or an encapsulant configured to encapsulate the back of the substrate 102.

At 330, the method 200 may include cutting (sawing or singulating) the microelectronic package array 100 to produce one or more microelectronic packages 332. The microelectronic package 332 may be covered by a conformal coating or an encapsulant 322 on the back surface and by a conformal coating or encapsulant 112 on the active side.

In one or more embodiments, the method 200 may be used with lead frame-based packages as well as with fan-out wafer-level chip scale packages (FO-WLCSP), flip-chip packages, mold-array process ball grid array (MAP BGA), and other circuit packages. In one or more embodiments, using pre-patterned backing tape 110 as part of the assembly process may reduce overall production time by providing a pre-patterned insulative layer without requiring additional masking plus photo-imaging or laser ablation processes to expose the contact pads 106 on the backside of the substrate 102. In one or more embodiments, unlike lead frames that require an underside cavity to compensate for the height of components before backing tape can be attached for the mold reflow process, a stepped lead frame (or lead frame with underside cavity) is not necessary for the process described herein. Unlike conventional circuits that may include extended leads for battery attachment, the pre-patterned backing tape 110 enables direct connection of the battery or other circuit components to the package, reducing the overall size of the microelectronic package 332.

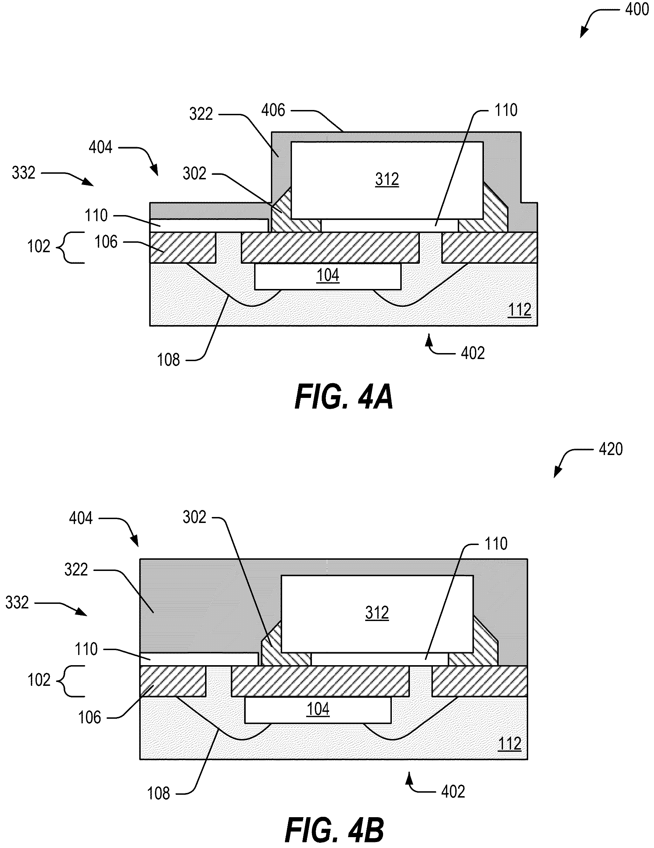

FIG. 4A depicts a cross-sectional view 400 of the microelectronic package 332 of FIG. 3 including an encapsulant 322 deposited as a conformal coating, in accordance with one or more embodiments. The microelectronic package 332 may include the substrate 102 including contact pads 106 separated by dielectric material 107. The microelectronic package 332 may include a circuit die 104 coupled directly to one of the contact pads 106 and coupled to adjacent contact pads 106 by bond wires 108. The active side 402 of the substrate 102 may be encapsulated by a conformal coating or an encapsulant 112. In the illustrated embodiment, the substrate 102 is depicted as a single layer of metal. In other embodiments, the substrate 102 may include one or more metal layers, one or more dielectric layers, and electrical interconnects extending between the metal layers.

The backside surface 404 of the substrate 102 may include the first portion 122 of the pre-patterned backing tape 110 (with the patterned portion 124 removed). The microelectronic package 332 may include electrically conductive material 302 coupled to selected contact pads 106 and to a circuit component 312. In one or more embodiments, the circuit component 312 may be a battery, such as a coin battery, or circuit components, such as a resistor, an inductor, a capacitor, or other passive circuit element. The backside surface 404 of the substrate 102 may be sealed by an encapsulant 322, such as a potting compound.

In one or more embodiments, instead of encapsulating the back surface 404 with a potting compound, the back surface 404 of the substrate 102 may be sealed by a conformal coating. An example of an embodiment of the circuit 332 including a conformal coating is described below with respect to FIG. 4B.

FIG. 4B depicts a cross-sectional view 420 of the microelectronic package 332 of FIG. 3 including an encapsulant 322, in accordance with one or more embodiments. In the illustrated example, the microelectronic package 332 includes all the elements of the microelectronic package 332 in FIG. 4A except that the back surface 404 of the substrate 102 is sealed with an encapsulant 322 deposited as a conformal coating.

In the illustrated embodiments of FIGs. 4A and 4B, the circuit component 312 (e.g., one or more of a battery or circuit components) may be significantly larger than microelectronic packages 332. The pre-patterned backing tape 110 may enable coupling of one or more coin batteries, one or more circuit elements, or any combination thereof to the contact pads 106 on the back surface 404 of the substrate 102.

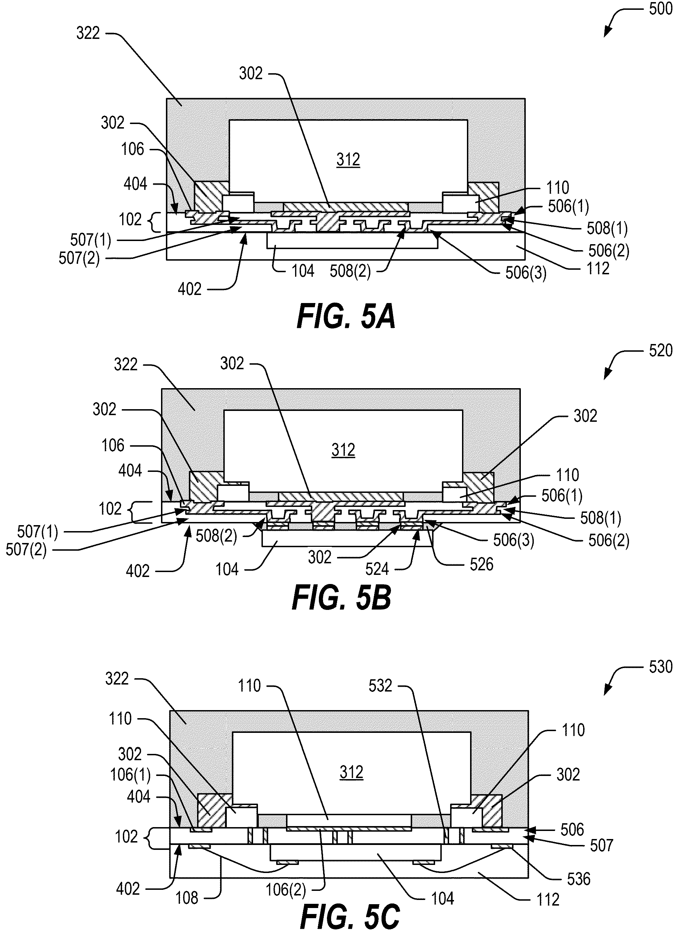

In the examples described above with respect to FIGs. 1A-4B, the pre-patterned backing tape 110 was applied to the back surface 404 of the substrate 102 that was implemented as a lead frame; however, the methods described herein are not limited to lead-frame packages. In one or more embodiments, the pre-patterned backing tape 110 may be used with various package platforms. In FIGs. 5A, 5B, and 5C, the pre-patterned backing tape 110 is used to expose the contact pads of a back surface of a fan-out wafer-level chip package, a flip chip package, and a mold-array process ball grid array package, respectively, to couple to a coin battery or circuit component.

FIG. 5A depicts an embodiment of the microelectronic package 332 of FIG. 3 implemented as a fan-out wafer-level chip package (FO-WLCP) 500, in accordance with one or more embodiments. The microelectronic package 332 may include a substrate 102 implemented as an FO-WLCP. The substrate 102 may include multiple metal layers 506 separated by dielectric layers 107. The substrate 102 may also include electrically conductive vias 508 that extend between metal layers 506. A metal layer 506(1) may include the contact pads 106 on the back surface (non-active circuit side) of the substrate 102. The active side of the substrate 102 may include a metal layer 506(3), which may include contact pads that may be coupled to a circuit die 104. The microelectronic package 332 may include an encapsulant 112 that extends over the circuit die 104 and the active surface 402.

The back surface 404 of the substrate 102 may include the first portion 122 of the pre-patterned backing tape 110. The electrically conductive material 302 may be applied to the contact pads 106 to couple a circuit component 312 (e.g., one or more of a battery or circuit components) to the contact pads 106. The backside surface 404 may be coated with a potting compound or encapsulant 322.

FIG. 5B depicts an embodiment of the circuit 332 of FIG. 3 implemented as a flip-chip package 520, in accordance with one or more embodiments. In this example, the substrate 102 may be coupled to a circuit die in a flip chip package. The substrate 102 may include multiple metal layers 506 separated by dielectric layers 107 and interconnected between metal layers 506 through the dielectric layers 107 by electrically conductive vias 508.

In the illustrated embodiment, a circuit die may include contact pads 524, which may be coupled by electrically conductive material (e.g., an electrically conductive adhesive (ECA) or solder) 302 to contact pads associated with one of the metal layers 506(3) on the active side 402 of the substrate 102. An encapsulant 526 may be applied over the contact pads 524 and the electrically conductive material 302 and at least partially over the edge of the circuit die to seal the electrical interconnections.

The back surface 404 of the substrate 102 may include the first portion 122 of the pre-patterned backing tape 110. A circuit component 312 (e.g., one or more of a battery or circuit components) may be electrically coupled to exposed contact pads 106 by electrically conductive material 302. The back surface 404 of the substrate 102, the electrically conductive material 302, and the circuit component 312 may be encapsulated by a potting compound or other encapsulant 322.

FIG. 5C depicts an embodiment of the microelectronic package 332 of FIG. 3 implemented as a mold-array process ball grid array (MAP BGA) 530, in accordance with one or more embodiments. In the illustrated example, the substrate 102 may include one or more metal layers 506, one or more portions of which may be exposed to provide contact pads 106 on the back surface 404 and contact pads 536 on the active side 402 of the substrate 102. A circuit die may be coupled by a BGA on the circuit die and contact pads (not shown) on the active surface 402 of the substrate 102. The circuit die may also be coupled to contact pads 536 of the substrate 102 by bond wires 108 and sealed by an encapsulant 112.

In one or more embodiments, the substrate 102 may include electrical traces, conductive vias 532, and metal layers 506 to electrically couple the circuit die to a circuit component 312 (e.g., one or more of a battery or circuit components) on the back surface 404 of the substrate 102. The back surface 404 of the substrate 102 may include contact pads 106(1) and 106(2). The first portion 122 of the pre-patterned backing tape 110 may cover the contact pad 106(2). The exposed contact pad 106(1) may be coupled to the circuit component 312 by electrically conductive material 302. The back surface of the substrate 102, including the electrically conductive material 302, the pre-patterned backing tape 110, and the circuit component 312 may be sealed by an encapsulant 322.

The embodiments of the microelectronic package 332 in FIGs. 4A-5C include the first portion 122 of the pre-patterned backing tape 110 that is left behind after removal of the patterned portion 124, exposing contact pads on the back surface 404 of the substrate 102. The first portion 122 may operate as a dielectric mask to prevent ECA or solder from overflowing and inadvertently creating electrical shorts or other undesired electrical connections. Additionally, the first portion 122 may electrically isolate portions of the attached battery or electrical component from the substrate 102. The pre-patterned backing tape 110 may be used in connection with various circuit platforms and is applicable to coin batteries as well as other passive circuit components, such as resistors, capacitors, inductors, and other circuit elements.

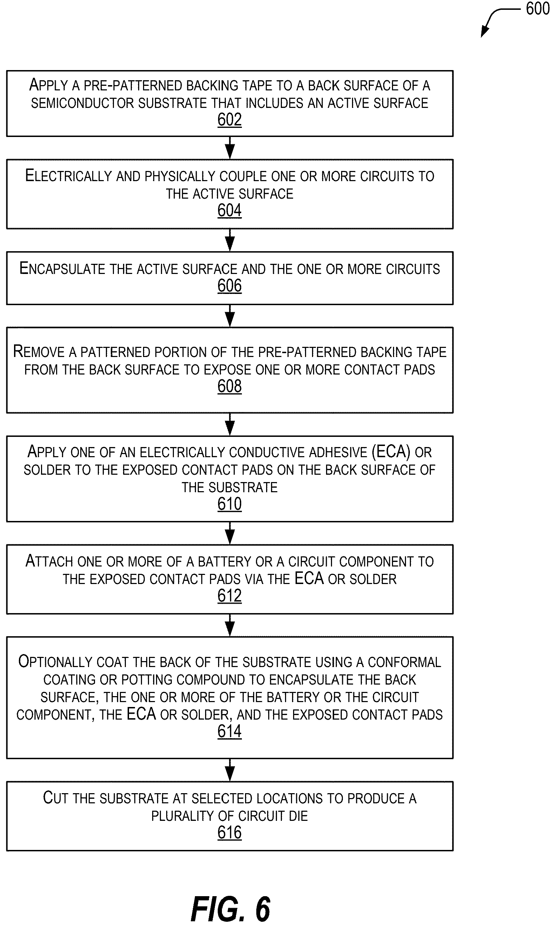

FIG. 6 depicts a flow diagram of a method 600 of producing a circuit die using a pre-patterned adhesive tape, in accordance with one or more embodiments. At 602, the method 600 may include applying a pre-patterned backing tape to a back surface of a semiconductor substrate that includes an active surface. The pre-patterned backing tape 110 may include a first portion 122 and a patterned portion 124. The patterned portion 124 may be removed, leaving the first portion 122 to expose selected areas of the back surface of the substrate 102. In one or more embodiments, the pre-patterned backing tape 110 may have a pattern selected to match contact pads on the back surface of the substrate 102.

At 604, the method 600 may include electrically and physically coupling one or more circuits to the active surface. In one or more embodiments, electrically conductive material 302 may be applied to contact pads on the active surface, and a circuit die may be coupled to the contact pads. In one or more embodiments, the resulting circuit may be lead frame-based package, an FO-WLCSP-based package, a flip-chip based package, a MAP-BGA package, or another type of circuit package.

At 606, the method 600 may include encapsulating the active surface and the one or more circuits. A potting compound, a resin, or another encapsulant may be applied over the circuit die and the active surface 402 (including over any electrical contact pads, wire bonds, ECA, solder, or other elements) to provide a molded circuit substrate. The pre-patterned backing tape 110 may prevent resin bleed and protect electrical contact terminals or pads on the back surface 404 of the substrate 102.

At 608, the method 600 may include removing a patterned portion of the pre-patterned backing tape from the back surface to expose one or more contact pads. The patterned portion 124 may be removed, leaving the first portion 122 of the pre-patterned backing tape 110. The patterned portion 124 may correspond to the location of one or more contact pads 106 on the back surface 404 of the substrate 102 such that removal of the patterned portion 124 exposes the one or more contact pads 106 through the pre-patterned backing tape 110.

At 610, the method 600 may include applying one of an ECA or solder to the exposed contact pads on the back surface of the substrate. In one or more embodiments, ECA may be dispensed onto the exposed contact pads or solder may be screen printed or otherwise applied to the contact pads.

At 612, the method 600 may include attaching one or more of a battery or a circuit component to the exposed contact pads via the ECA or solder. In one or more embodiments, one or more batteries or one or more circuit components may be coupled to the exposed contact pads. The first portion 122 of the pre-patterned backing tape 110 may provide electrical isolation between the back surface 404 of the substrate 102 and the one or more circuit components 312 (e.g., one or more of a battery or circuit components) between the exposed contact pads 106.

At 614, the method 600 may include optionally coating the back surface of the substrate using a conformal coating or potting compound to encapsulate the back surface, the one or more of the battery or the circuit component, the ECA or solder, and the exposed contact pads. In one or more embodiments, a conformal coating may be disposed onto the back surface 404 of the substrate 102, as described with respect to FIG. 3 and FIG. 4A. In one or more embodiments, a potting compound may be disposed on the back surface 404 of the substrate 102, as described with respect to FIG. 3 and FIG. 4B.

At 616, the method 600 may include cutting the substrate at selected locations to produce a plurality of circuit die. In one or more embodiments, the substrate 102 may be cut at scribe lanes to singulate the die, producing multiple microelectronic package 332.

The embodiment of the method 600 in FIG. 6 is presented for illustrative purposes and is not intended to be limiting. In one or more embodiments, changes in the order of the method 600 may be made without departing from the scope of the disclosure. In an example, the pre-patterned backing tape of 602 may be applied after coupling circuits to the active circuit in 604. Other changes may also be made.

One or more embodiments of the disclosure may be further understood in view of the Examples presented below.

Example 1: A method of producing a circuit die where the method includes applying a pre-patterned backing tape to a first surface of a semiconductor substrate that includes the first surface and a second surface, the second surface including one or more circuits; coating the second surface with an encapsulant; removing a patterned portion of the pre-patterned backing tape to expose one or more contact pads on the first surface; applying one of an electrically conductive adhesive (ECA) or solder to the one or more contact pads on the first surface; and coupling an electrical component to the contact pads using the ECA or solder.

Example 2: The method of Example 1, where, before applying the pre-patterned backing tape, the method further including selecting the pre-patterned backing tape.

Example 3: The method of any of the Examples 1-2, further including coating the first surface with a second encapsulant.

Example 4: The method of Example 3, where the second encapsulant includes a conformal coating.

Example 5: The method of Example 3, where the second protective layer can be an encapsulant or conformal coating.

Example 6: The method of any of the Example 1-5, where the pre-patterned backing tape is non-conductive.

Example 7: The method of any of the Examples 1-6, during the coating of the second surface, the method includes preventing resin bleed by the pre-patterned backing tape.

Example 8: The method of any of the Examples 1-7, where the electrical component includes a battery.

Example 9: The method of any of the Examples 1-8, where the electrical component includes one or more of a resistor, an inductor, or a capacitor.

Example 10: The method of any of the Examples 1-9, where during the applying the one of the ECA or the solder, preventing, by a remaining portion of the pre-patterned backing tape, the ECA or the solder from contacting adjacent contact pads.

Example 11: The method of any of the Examples 1-10, where the semiconductor substrate includes one of a lead frame package, a fan-out wafer-level chip scale package, a flip-chip package, or a mold-array process ball grid array package.

Example 12: A device including a circuit package including a semiconductor substrate including an active surface and a second surface, the semiconductor substrate including a circuit coupled to one or more contact pads of an active surface of the semiconductor substrate and including an encapsulant material disposed on the active surface and at least partially over the circuit; a patterned backing tape coupled to the second surface of the semiconductor substrate, the patterned backing tape including a remaining portion including openings corresponding to a pattern of a removed patterned portion, the openings at least partially aligned with one or more contact pads on the second surface of the semiconductor substrate; and a circuit component coupled to the one or more contact pads on the second surface of the semiconductor substrate.

Example 13: The device of Example 12, where the circuit component includes a battery.

Example 14: The device of any of the Examples 12-13, where the circuit component includes one or more of a resistor, a capacitor, or an inductor.

Example 15: The device of any of the Examples 12-14, further including one of an electrically conductive adhesive or a solder on the one or more contact pads to electrically and mechanically couple the circuit component to the one or more contact pads.

Example 16: The device of any of the Examples 12-15, further including a second encapsulant material disposed on the second surface of the semiconductor substrate and optionally over the circuit component.

Example 17: The device of Example 16, where the second protective material includes a conformal coating.

Example 18: The device of Example 16, where the second protective material includes an encapsulant.

Example 19: The device of any of the Examples 12-19, where the circuit package includes one of a lead frame package, a fan-out wafer-level chip scale package, a flip-chip package, or a mold-array process ball grid array package.

Example 20: The device of any of the Examples 12-19, where the pre-patterned backing tape is non-conductive.

The preceding detailed description is merely illustrative in nature and is not intended to limit the embodiments of the subject matter or the application and uses of such embodiments. As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, or detailed description.

The connecting lines shown in the various figures contained herein are intended to represent exemplary functional relationships and/or physical couplings between the various elements. It should be noted that many alternative or additional functional relationships or physical connections may be present in an embodiment of the subject matter. In addition, certain terminology may also be used herein for the purpose of reference only, and thus are not intended to be limiting, and the terms "first", "second" and other such numerical terms referring to structures do not imply a sequence or order unless clearly indicated by the context.

The foregoing description refers to elements or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with, electrically or otherwise) another element, and not necessarily mechanically. Thus, although the schematic shown in the figures depict one exemplary arrangement of elements, additional intervening elements, devices, features, or components may be present in an embodiment of the depicted subject matter.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims.

## Claims

1. A method of producing a circuit die, the method comprising:
applying a pre-patterned backing tape to a first surface of a semiconductor substrate that includes the first surface and a second surface, the second surface including one or more circuits;
coating the second surface with an encapsulant;
removing a patterned portion of the pre-patterned backing tape to expose one or more contact pads on the first surface;
applying one of an electrically conductive adhesive (ECA) or solder to the one or more contact pads on the first surface; and
coupling an electrical component to the contact pads using the ECA or solder.

2. The method of claim 1, wherein, before applying the pre-patterned backing tape, the method further comprising selecting the pre-patterned backing tape.

3. The method of claim 1 or claim 2, further comprising coating the first surface with a second encapsulant.

4. The method of claim 3, wherein the second protective material comprises a conformal coating.

5. The method of claim 3, wherein the second protective material comprises an encapsulant.

6. The method according to any preceding claim, wherein the pre-patterned backing tape is non-conductive.

7. The method according to any preceding claim, during the coating of the second surface, the method comprises preventing resin bleed by the pre-patterned backing tape.

8. The method according to any preceding claim, wherein the electrical component comprises a battery.

9. The method according to any preceding claim, wherein the electrical component comprises one or more of a resistor, an inductor, or a capacitor.

10. The method according to any preceding claim, wherein during the applying the one of the ECA or the solder, preventing, by a remaining portion of the pre-patterned backing tape, the ECA or the solder from contacting adjacent contact pads.

11. The method according to any preceding claim, wherein the semiconductor substrate comprises one of a lead frame package, a fan-out wafer-level scale chip package, a flip-chip package, or a mold-array process ball grid array package.

12. A device comprising:
a circuit package including a semiconductor substrate including an active surface and a second surface, the semiconductor substrate including a circuit coupled to one or more contact pads of an active surface of the semiconductor substrate and including an encapsulant material disposed on the active surface and at least partially over the circuit;
a patterned backing tape coupled to the second surface of the semiconductor substrate, the patterned backing tape including a remaining portion including openings corresponding to a pattern of a removed patterned portion, the openings at least partially aligned with one or more contact pads on the second surface of the semiconductor substrate; and
a circuit component coupled to the one or more contact pads on the second surface of the semiconductor substrate.

13. The device of claim 12, wherein the circuit component comprises at least one of a battery, one or more of a resistor, a capacitor, or an inductor.

14. The device of claim 12 or claim 13, further comprising one of an electrically conductive adhesive or a solder on the one or more contact pads to electrically and mechanically couple the circuit component to the one or more contact pads.

15. The device according to any of claim 12 to claim 14, further comprising a second encapsulant material disposed on the second surface of the semiconductor substrate and optionally over the circuit component.
